# EUROPEAN PATENT APPLICATION

(11) **EP 4 047 627 A1**
(43) Date of publication of application: **24.08.2022**
(21) Application number: 21157670.7
(22) Date of filing: 17.02.2021
(51) Int. Cl.: H01H 13/70, B60K 37/06, H03K 17/96, G06F 3/0354, G06F 3/044

(54) **SWITCH**

(71) Applicant: Aptiv Technologies Limited, St. Michael (BB)
(72) Inventor: LIPKA, Janusz, Dublin, 2 (IE); BOHDAN, Lukasz, Dublin, 2 (IE); MUCHA, Rafal, Dublin, 2 (IE)
(74) Representative: Gaunt, Thomas Derrick

(57) **Abstract**

Switch (10) having a first part (1) and a second part (2). The switch (10) is configured to activate in response to a switch sequence including activation of the first part (1) followed by activation of the second part (2). One of the first (1) and second parts (2) includes a touch sensor (1a-f) and is configured to activate in response to a first switching method in which a user moves a digit along a predetermined digit path over the touch sensor (1a-f). The other of the first (1) and second (2) parts is activatable in response to a second switching method different from the first switching method.

## Description

### Introduction

The present disclosure relates to a switch and is particularly relevant to two-step switches and switches having misuse protection.

### Background

Some switch applications require misuse protection in order to prevent inadvertent activation of the switch. In such situations, typically a two-step process is needed to activate the switch, thereby ensuring that a switching operation only occurs when intended.

To facilitate the above, a common conventional solution is to have a switch controlled by two sub-switches that are physically separated from one another, and require one or two operators to activate both parts simultaneously. Another conventional solution is to provide a guard over a switch, such as a press, toggle, or slide switch. That way, the method of operating the switch (e.g., by pressing, toggling or sliding) is only possible once a user has physically opened the guard.

Although the above conventional solutions are effective at preventing inadvertent activation, they require space and, as such, are unsuitable for use in smaller devices or in situations where space is at a premium. For example, in automotive applications, space on the dashboard and central console is relatively limited and therefore it is not possible, or is aesthetically unsatisfactory, to include multiple switch parts or guarded switches. There therefore remains a need for an improved switch for mitigating the risk of inadvertent activation, but which is also compact.

### Summary

According to a first aspect, there is provided a switch, including: a first part and a second part, wherein the switch is configured to activate in response to a switch sequence including activation of the first part followed by activation of the second part, wherein one of the first and second parts includes a gesture sensor and is configured to activate in response to a first switching method including a user performing a predetermined gesture; and wherein the other of the first and second parts is activatable in response to a second switching method different from the first switching method.

In this way, a switching device may be provided which includes two separate activation fields that need to be activated in different ways, and in sequence, in order to activate the switch. Accordingly, the arrangement requires the user's attention in order for them to correctly operate each of the switch parts in turn, and the different methods mitigate the risk of accidental operation when they are not paying attention. Furthermore, the use of a gesture sensor necessitates the user's sustained awareness while they perform the predetermined gesture, which further mitigates the risk of accidental operation. Moreover, the combination of a gesture switching method with a different switching method allows for the switch parts to be co-located for a compact device footprint.

In embodiments, the gesture sensor is a touch sensor. In embodiments, the predetermined gesture includes a user moving a digit along a predetermined digit path. In this way, a touch sensor, such as a capacitive touch sensor, may be used to determine whether a user has performed a required gesture, such as drawing a shape with their finger by moving it along a digit path over the touch sensor.

In embodiments, the second switching method includes a pressing a button on the other of the first and second parts. In this way, a simple press trigger may be provided for activating one of the stages. As such, whilst the first switching method requires a relatively complex user gesture, the second switching method of pressing a button allows for simple operation.

In embodiments, the button on the other of the first and second parts includes a button field and the respective part is activatable in response to a user pressing the button field with a digit. In embodiments, the button field may be provided by a capacitive touch sensor for detecting a user's finger. In other embodiments, the button field may be provided by a mechanical button element.

In embodiments, the touch sensor includes a plurality of activatable touch sensor zones arranged along the digit path, and wherein the first switching method includes the sequential activation of the touch sensor zones when the user moves the digit along the digit path. In this way, a simple sensor arrangement is provided where the identification of the predetermined gesture may be ascertained from the sequence in which the sensor zones are activated. Consequently, the device does not need to track a user's finger in high resolution. Instead, coarse sensor zones and a basic logic function can be used to differentiate between valid user gestures, where zones are activated in a determined order, and random activations which result from a user inadvertently contacting the sensor.

In embodiments, the sequential activation of the touch sensor zones includes sequentially activating adjacent touch sensor zones, starting with any one of the touch sensor zones. In this way, a user has flexibility to commence the performance of the user gesture from any zone, with the validity of the movement being verified based on a continuous movement from one zone to the next through the zones. This thereby provides improved flexibility, whilst making it difficult for inadvertent user contact with the sensor to replicate the same sequence.

In embodiments, the switch further includes one or more digit path indicators arranged along the digit path. In this way, a user is provided with an indication to help them replicate the required gesture.

In embodiments, at least one of the one or more digit path indicators include a surface formation for providing a tactile indicator of the digit path. In this way, the surface formation can help to guide the user's finger for replicating the required gesture.

In embodiments, the surface formation includes a channel defining the digit path. In this way, a user can easily move their finger along the channel to perform the predetermined gesture.

In embodiments, the digit path surrounds at least a portion of the other of the first and second parts. As such, the digit path may be provided as a circle or circular path around the one of the first and second parts, to provide a switch with a compact footprint.

In embodiments, the digit path encloses a pressable trigger of the other of the first and second parts. In this way, a longer digit path may be accommodated, whilst maintaining a relatively compact switch footprint.

In embodiments, the digit path is a circular path. As such, the part may be activated by a user making a smooth continuous looping gesture with their finger.

In embodiments, the switch further includes a switch sequence indicator, wherein the switch sequence indicator is configured to activate in response to the first part being activated before activation of the second part. In this way, the user may be provided with feedback to indicate they have a valid activation of the first part, before they attempt to activate the second.

In embodiments, the sequence indicator may include a progressive indicator for indicating the progression of the switching method ending with the activation of the first part. For example, in embodiments, the progressive indicator may indicate the progress of a user performing the predetermined gesture.

In embodiments, the switch sequence indicator includes an indicator light. As such, the user is provided with a visual indicator.

In embodiments, the switch further includes a timer for timing from the activation of the first switch, and for deactivating the first switch to reset the switch sequence if the second switch is not activated within a threshold response time. In this way, the switch sequence must be performed within a certain time in order to validly activate the switch. This provides a cadence requirement which further mitigates the risk of inadvertent operation of the switch.

In embodiments, the switch further includes a switch controller for receiving inputs from the first and second parts and for determining the activation of the parts based thereon.

### Brief Description of Drawings

An illustrative embodiment will now be described with reference to the accompanying drawings in which:
Figure 1 shows a plan view of a segmented touch sensor element of a switch according to the illustrative embodiment;
Figure 2 shows a perspective view of a sensor surface of a switch according to the illustrative embodiment; and
Figure 3 shows an exploded view of the switch assembly according to the first embodiment, including the sensor element and sensor surface assembly.

### Detailed Description

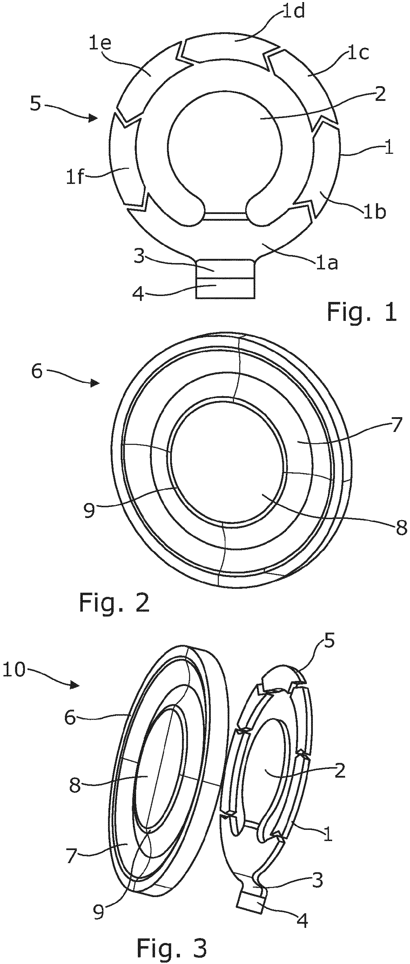

Figures 1 to 3 show a switch 10 according to an illustrative embodiment. As shown in the exploded view in Figure 3, the rear side of the switch includes a segmented touch sensor element 5, which is overlayed by a sensor surface 6. Once assembled, the assembly forms a touch sensor where user contact with the sensor surface 6 is detected by the touch sensor element 5.

Figure 1 shows a plan view of a segmented touch sensor element 5, which includes an outer field 1 defined by a circular path and inner field 2 surrounded by the outer field 1. These fields form two functional parts of the switch associated with different steps of the two-step switching process. In this embodiment, the touch sensor element 5 is a capacitive touch sensor having a plurality of activatable sensor zones, as is described in further detail below. The touch sensor element 5 is connected via a connector 3 to a controller 4 which interprets signals from the sensor zones.

The outer field 1 includes a plurality of sensor zones 1a-f defining a circular path around the exterior of the inner field 2. Each of the sensor zones 1a-f is independently activatable in response to a detected change in capacitance caused by a user's finger over the respective sensor zone.

The inner field 2 is defined by a single central button sensor zone which is formed as a circular tab extending up from the bottom sensor zone 1a of the outer field 1, but operably separated therefrom. As such, the central button sensor zone 2 is activatable independently of activation of the surrounding outer field sensor zones 1a-f. Again, this is detected by a change in capacitance caused by a user's finger over the zone.

Figure 2 shows the sensor surface 6 which sits over touch sensor element 5 in the assembled switch. The sensor surface 6 includes an outer channel 7 surrounding an inner button 8. The outer channel 7 is configured to overlay the outer field 1 of the touch sensor element 5 and forms a continuous loop for guiding a user's finger in a circular path. As such, in use, when a user places their finger into the groove formed by the channel 7, they activate the respective underlying sensor zone 1a-f of the outer field 1. Furthermore, by moving their finger around the channel 7, the user can activate the underlying sensor zone 1a-f in sequence, with each zone activated in turn.

The button 8 of the sensor surface 6 is provided as a flattened circular plateau surrounded by an indicator light 9 and then the channel 7 in a concentric arrangement. The button 8 overlays the central button sensor zone 2 and hence allows a user to activate the central button sensor zone 2 by pressing their finger against the surface of the button 8. The indicator light 9 is controlled by the controller 4 and is used to indicate when the button 8 is armed, ready for activation.

In use, the switch is activated in response to a switch sequence beginning with the activation of the outer field 1, followed by activation of the inner field 2.

In the first step of the sequence, a user places their finger into the channel 7, and then moves their finger around the groove to complete a counterclockwise circular gesture. This results in activation of the underlying sensor zones 1a-f in order, starting from the zone underlying the position on the channel 7 where the user first placed their finger. As the user's finger moves, the controller 4 identifies that each sensor zone 1a-f is activated in turn around the circle and identifies this as a valid gesture indication. For example, if the user's finger begins at the top of the circle, over sensor zone 1d, a valid counterclockwise circle gesture would be determined if sensor zones 1e, 1f, 1a, 1b, and 1c were activated in turn. Conversely, an invalid gesture is identified if a sensor zone out of sequence (e.g. such as 1d followed by 1f) or in an incorrect sequence (e.g. clockwise, rather than counterclockwise) is activated. In embodiments, the sensor surface 6 may further include visual markers to indicate to a user the correct direction of motion along the digit path to activate the outer field.

If the controller 4 determines that the user has performed a valid counterclockwise circular gesture, it triggers the indicator light 9 to turn on. This alerts the user that the first switching step has been completed and the button 8 is now armed for activation.

Once the button 8 is armed, if the user wishes to proceed to activate the switch, they can then perform a pressing motion by placing their finger on the button 8. In this embodiment, the controller 4 requires the central button sensor zone 2 to detect the presence of a finger for a sustained period of over two seconds. This thereby mitigates the risk of a glancing contact with the button 8 causing accidental triggering of the switch. Once sustained contact is detected, the controller 4 determines that the switch sequence has completed and activates the switch.

The controller 4 also includes a sequence timer, which is triggered once the first switching step has been completed. If the button 8 is not activated within a threshold time, the controller 4 resets the switch sequence and the button 8 is disarmed. In this embodiment, the threshold time is set at five seconds, and the controller 4 causes the indicator light 9 to flash after three seconds to alert the user that the sequence is due to reset. In this way, activation of the outer field 1 is time limited by the controller 4, and hence a failure to complete the full switch sequence within a specified time will require the user to restart the sequence from the beginning. This thereby prevents a user from leaving the button 8 armed for an extended period in which it could get unintentionally triggered.

With the above switch arrangement, the outer field 1 is activated using a first switching method in which the user performs a counterclockwise circle gesture. This thereby functions as a misuse protection step. The inner field 2 may then only be activated after completing the first step, and requires a second switching method in which the user presses the button 8 for a sustained period. Consequently, both methods are required in a defined sequence. For example, a glancing contact, which could feasibly mimic the circling motion required by the first switching method, would not replicate the sustained pressure required by the second, pressing method. As such, the switch is only activated if a user performs the correct sequence of switch operations in a controlled manner.

The switch device may thereby provide a compact arrangement for controlling the switching of important functions which should not be routinely switched. For example, the switch may be used to turn off a safety system within a vehicle, whereby deactivation may be necessary in some circumstances but only with the driver's additional confirmation. As one example, it may be necessary to disable automatic parking brake functions if a vehicle is to be towed, but inadvertent deactivation of this function is potentially dangerous in other use conditions.

It will be understood that the embodiment illustrated above shows an application only for the purposes of illustration. In practice, embodiments may be applied to many different configurations, the detailed embodiments being straightforward for those skilled in the art to implement.

In this connection, for example, in the above embodiment, the switch has been configured so that the gesture switching method is associated with the first step of the switch sequence. However, in other embodiments, it will be understood that another switching method may be used as a first step, followed by the gesture as a second step. Furthermore, the controller may also allow the switch sequence to be initiated starting with either step first. For instance, a user may activate the outer or inner field in a first step, followed by the other field in the second. This may be helpful in emergency situations by providing the user with greater flexibility to activate the switch.

Furthermore, in the above embodiment, the button 8 has been implemented using a capacitive touch sensor. However, it will be understood that a mechanical button could be used. Moreover, other trigger types, such as toggle or slide triggers, could also alternatively be used.

Moreover, although a light indicator has been described in the above embodiment, other indicators and feedback mechanisms may also be used to identify the successful activation of the first field. For example, other visual or audible indicators may be provided. The switch may also be configured to provide haptic feedback. Combinations of indicators may also be used.

Further still, although in the above embodiment, a fixed channel is provided as a predetermined digit path, it will be understood that in other embodiments, the predetermined gesture may change periodically to prevent switching becoming a habit or instinctive for the user. For example, in embodiments, the gesture sensor may be implemented on a touch sensitive display, and a user may be required to follow different digit paths dependent on the specific path indicator shown on the display during a switching operation. In embodiments, the gesture sensor may be implemented on a touch sensitive display of a vehicle.

In other embodiments, the gesture sensor may include a spatial movement sensor for tracking a user's movement in space. For example, the spatial movement sensor may be a camera or camera array, or may include other movement sensors such as ultrasonic, radar or LiDAR sensors. In embodiments, the user may be shown a shape on a display and the predetermined gesture includes a user reproducing the displayed shape using a physical gesture tracked by the spatial movement sensor. Again, in embodiments, the displayed shape may periodically change so as to task the user with reproducing different physical gestures in order to ensure their conscious affirmation of the switching action.

Finally, in embodiments the switch may be provided as a switch for switching a function in a vehicle. In some vehicle switch embodiments, the first part may be locatable at a first location in the vehicle's interior and the second part may be locatable at a second location, different from the first location. For example, one of the first and second parts may be provided as a pressable button at one location, and the second part may be provided as the gesture sensor at a different location. For instance, a button may be provided on the vehicle's roof, door, or central console, which can be used in a first step to trigger a dashboard display to present a gesture indicator. To activate the switching function, the user may then replicate the specified gesture in a second step. This may be effected by the user performing a physical gesture in the air in embodiments having spatial motion tracking, or by following the digit path on the display screen with their finger in embodiments having a touch screen.

## Claims

1. A switch, comprising:
a first part and a second part, wherein the switch is configured to activate in response to a switch sequence comprising activation of the first part followed by activation of the second part,
wherein one of the first and second parts comprises a gesture sensor and is configured to activate in response to a first switching method comprising a user performing a predetermined gesture; and
wherein the other of the first and second parts is activatable in response to a second switching method different from the first switching method.

2. A switch according to claim 1, wherein the second switching method comprises pressing a button on the other of the first and second parts.

3. A switch according to claim 1 or 2, wherein the gesture sensor is a touch sensor, and the predetermined gesture includes a user moving a digit along a predetermined digit path over the touch sensor.

4. A switch according to claim 3, wherein the touch sensor comprises a plurality of activatable touch sensor zones arranged in the digit path, and wherein the first switching method comprises the sequential activation of the touch sensor zones when the user moves the digit along the digit path.

5. A switch according to claim 4, wherein the sequential activation of the touch sensor zones comprises sequentially activating adjacent touch sensor zones, starting with any one of the touch sensor zones.

6. A switch according to any of claims 3-5, further comprising one or more digit path indicators arranged along the digit path.

7. A switch according to claim 6, wherein at least one of the one or more digit path indicators comprise a surface formation for providing a tactile indicator of the digit path.

8. A switch according to claim 7, the surface formation comprises a channel defining the digit path.

9. A switch according to any preceding claim, wherein the digit path surrounds at least a portion of the other of the first and second parts.

10. A switch according to claim 9, wherein the digit path encloses a pressable trigger of the other of the first and second parts.

11. A switch according to any one of claims 9 or 10, wherein the digit path is a circular path.

12. A switch according to any preceding claim, further comprising a switch sequence indicator, wherein the switch sequence indicator is configured to activate in response to the first part being activated before activation of the second part.

13. A switch according to claim 12, wherein the switch sequence indicator comprises an indicator light.

14. A switch according to any preceding claim, further comprising a timer for timing from the activation of the first switch, and for deactivating the first switch to reset the switch sequence if the second switch is not activated within a threshold response time.

15. A switch according to any preceding claim, further comprising a switch controller for receiving inputs from the first and second parts and for determining the activation of the parts based thereon.
